# EUROPEAN PATENT SPECIFICATION

(11) **EP 3 428 297 B1**
(45) Date of publication and mention of the grant of the patent: **23.09.2020**
(21) Application number: 17763149.6
(22) Date of filing: 06.03.2017
(51) Int. Cl.: C22C 19/05, F01D 5/28, F01D 25/00, F02C 7/00, C22F 1/00, C22F 1/10, C30B 29/52

(54) **Ni-BASED UNIDIRECTIONALLY SOLIDIFIED ALLOY**
NI-BASIERTE UNIDIREKTIONAL VERFESTIGTE LEGIERUNG
ALLIAGE À SOLIDIFICATION UNIDIRECTIONNELLE À BASE DE NICKEL

(30) Priority: 07.03.2016 JP 2016043875
(43) Date of publication of application: 16.01.2019
(73) Proprietor: National Institute for Materials Science, Tsukuba-shi, Ibaraki 305-0047 (JP)
(72) Inventor: KAWAGISHI Kyoko, Tsukuba-shi Ibaraki 305-0047 (JP); HARADA Hiroshi, Tsukuba-shi Ibaraki 305-0047 (JP); YOKOKAWA Tadaharu, Tsukuba-shi Ibaraki 305-0047 (JP); KOIZUMI Yutaka, Tsukuba-shi Ibaraki 305-0047 (JP); KOBAYASHI Toshiharu, Tsukuba-shi Ibaraki 305-0047 (JP); SAKAMOTO Masao, Tsukuba-shi Ibaraki 305-0047 (JP); YUYAMA Michinari, Tsukuba-shi Ibaraki 305-0047 (JP)
(74) Representative: Klang, Alexander H.
(86) International application number: PCT/JP2017/008676
(87) International publication number: WO 2017/154809

(56) References cited:
- WO-A1-2006/104059
- JP-A- H11 246 954
- JP-A- S62 116 748
- JP-A- 2005 097 650
- JP-A- 2007 211 273
- JP-A- 2014 034 720
- US-A1- 2006 113 009
- US-A1- 2008 240 926
- US-A1- 2015 197 833

## Description

### Technical Field

The present invention relates to Ni-based directionally solidified alloy that can be used preferably for a member such as a turbine blade and a turbine vane in a jet engine and a gas turbine, which is used at a high temperature and high stress, and particularly relates to Ni-based directionally solidified alloy that does not contain Co or Re as a main element.

### Background Art

Ni-based alloy has been developed as forging alloy, casting alloy, directionally solidified alloy and single crystal alloy, and its durable temperature has been improved accordingly. Ni-based single crystal alloy has superior high temperature strength to that of Ni-based directionally solidified alloy, but has problems of generating longitudinal cracks and anisotropic crystals during casting. In particular, a larger-sized member of Ni-based single crystal alloy is more likely to be effected by these problems, and its production yield tends to be lower, so that Ni-based directionally solidified alloy is superior in cost performance for the production.

Further, super alloys commonly have problems in creep property, thermo-mechanical fatigue property and environment-resistant characteristics. Since a rotating member in a turbine blade or the like is rotated at a high speed while being exposed to combustion gas at a high temperature, and centrifugal force is applied to the member, the member is required to endure creep at high stress. Such a high temperature member used for a turbine blade or a turbine vane in a jet engine or a gas turbine also has a problem of material deterioration due to thermos-mechanical fatigue (TMF), because it is often started and stopped. Further, since the high temperature member is exposed to combustion gas at a high temperature, it is expected to find a material having excellent environment-resistant characteristics.

As the Ni-based directionally solidified alloy, IN792 (Trade Mark) and Rene80 (Trade Mark) have been known, but both of IN792 and Rene80 contain Co in the alloys. Also, Ni-based alloys described in JP H11-246954 A1 or JP 2905473 B, JP 2006-45654 A, JP 2011-74493 A, JP 2004-197131 A, JP 2000-63969 A, JP H10-273748 A, JP H9-272933 A, and JP 2014-34720 A have been known, but each of the alloys described in these disclosures contains either or both elements of Co and Re in its component. Since Co is produced as a byproduct during the production of copper or nickel, a production amount of Co depends on a price situation of copper or nickel, and supply of Co is accordingly unstable. Re is a metal that is extremely scarce on the earth, and is the most rare and expensive metal among rare metals.

Further, the Ni-based directionally solidified alloy with Re added is difficult to be treated by heat after the casting, and a TCP phase is likely to be deposited and may affect high temperature strength, while it is used as a high temperature member. From these drawbacks, the use of Co or Re is not preferable because of their high temperature properties and cost performance as a large number, in particular. The Ni-based alloy disclosed in JP 2014-34720 A does not contain Co or Re, but is not preferable in the light of cost performance, because it is a Ni-based single crystal alloy.

US 2015/197833 A1 discloses a Ni-based single crystal superalloy containing 6% by mass or more and 12% by mass or less of Cr, 0.4% by mass or more and 3.0% by mass or less of Mo, 6% by mass or more and 10% by mass or less of W, 4.0% by mass or more and 6.5% by mass or less of Al, 0% by mass or more and 1% by mass or less of Nb, 8% by mass or more and 12% by mass or less of Ta, 0% by mass or more and 0.15% by mass or less of Hf, 0.01% by mass or more and 0.2% by mass or less of Si, and 0% by mass or more and 0.04% by mass or less of Zr, and optionally containing at least one element selected from B, C, Y, La, Ce, and V, with a balance being Ni and inevitable impurities.

JP H11-246954 A1 and JP 2905473 B disclose a manufacturing method of Ni group unidirectional solidification alloy comprising Co 10-14 wt%, Cr 2-3 wt%, Mo 1.5-2.5 wt%, W 5-6.5 wt%, Al 5.7-6.5 wt%, Ta 5.5-6.5 wt%, Re 4.5-5 wt%, Hf 0.01-0.3 wt%, C 0.01-0.3 wt%, B 0.01-0.03 wt% and remainder consisting of Ni and an unavoidable impurity, the method comprising a heat treatment of the unidirectional solidification alloy at a temperature of 1250-1300 °C. Then, at a temperature of 750-1200 °C, an aging treatment is carried out.

### Summary of Invention

### Technical Problem

It is an object of the present invention to provide first generation Ni-based directionally solidified alloy containing none of Co and Re, which has excellent TMF characteristics, creep property and environment-resistant characteristics, and is superior in cost performance in practical use.

### Solution to Problem

In order to solve the above-described problems, the present invention has following characteristics.

That is, the Ni-based directionally solidified alloy of the present invention consists of
Cr: 6% by mass or more and 12% by mass or less;
Mo: 0.4% by mass or more and 3.0% by mass or less;
W: 6% by mass or more and 10% by mass or less;
Al: 4.0% by mass or more and 6.5% by mass or less;
Nb: 0% by mass or more and 1% by mass or less;
Ta: 8% by mass or more and 12% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

Preferably, the Ni-based directionally solidified alloy of the present invention consists of
Cr: 7% by mass or more and 12% by mass or less;
Mo: 0.4% by mass or more and 2.5% by mass or less;
W: 7% by mass or more and 10% by mass or less;
Al: 4.0% by mass or more and 6.5% by mass or less;
Nb: 0% by mass or more and 1% by mass or less;
Ta: 9% by mass or more and 11% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

Still preferably, the Ni-based directionally solidified alloy of the present invention consists of
Cr: 8% by mass or more and 10% by mass or less;
Mo: 0.4% by mass or more and 2.0% by mass or less;
W: 7% by mass or more and 9% by mass or less;
Al: 4.0% by mass or more and 6.5% by mass or less;
Nb: 0% by mass or more and 1% by mass or less;
Ta: 10% by mass or more and 11% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

The Ni-based directionally solidified alloy of the present invention preferably has a creep life at a temperature of 900°C and stress of 392 MPa that is 65 hours or more, and a number of cycles in a thermo-mechanical fatigue (TMF) property test in predetermined operating conditions that is 155 cycles or more. Herein, the thermo-mechanical fatigue (TMF) property test is performed by simulating operating conditions of a gas turbine, in which a temperature of a surface of a turbine blade is assumed to be 900°C in a steady state and 400°C when the turbine blade stops, and a number of cycles until breaking a test piece that has a predetermined shape is evaluated. Details of the thermo-mechanical fatigue (TMF) property test will be specified in the specification.

Further preferably, a creep life at the temperature of 900°C and the stress of 392MPa is 65 hours or more and 115 hours or less, and the number of cycles in the TMF property test is 155 cycles or more and 215 cycles or less. Most preferably, the creep life at the temperature of 900°C and the stress of 392MPa is 75 hours or more and 105 hours or less, and the number of cycles in the TMF property test is 170 cycles or more and 195 cycles or less.

If the creep life is less than 65 hours, the creep life is not improved compared with those in the conventional examples. The creep life exceeding 115 hours is beyond an upper limit of the creep life of the Ni-based directionally solidified alloy of the present invention, even considering the variation of the results of the creep life test.

If the number of cycles in the thermo-mechanical fatigue (TMF) property test is less than 155 cycles, the TMF characteristic is not improved compared with those in the conventional examples. The number of cycles in the thermo-mechanical fatigue (TMF) property test exceeding 215 cycles is beyond an upper limit of the TMF characteristic of the Ni-based directionally solidified alloy of the present invention, even considering the variation of the results of the thermo-mechanical fatigue (TMF) property test.

The Ni-based directionally solidified alloy of the present invention preferably has a value of a Larson-Miller parameter at a temperature of 900°C and stress of 392 MPa which is 25.6 or more and 25.9 or less, and a value of a Larson-Miller parameter at a temperature of 1100°C and stress of 137 MPa which is 28.8 or more and 29.3 or less.

If the value of the Larson-Miller parameter at the temperature of 900°C and the stress of 392 MPa is less than 25.6, the creep life is not improved compared with those in the conventional examples. The value of the Larson-Miller parameter exceeding 25.9 is beyond an upper limit of the Larson-Miller parameter of the Ni-based directionally solidified alloy of the present invention, even considering the variation of the results of the creep life test for obtaining the Larson-Miller parameters.

If the value of the Larson-Miller parameter at the temperature of 1100°C and the stress of 137 MPa is less than 28.8, the creep life is not improved compared with those in the conventional examples. The value of the Larson-Miller parameter exceeding 29.3 is beyond an upper limit of the Larson-Miller parameter of the Ni-based directionally solidified alloy of the present invention, even considering the variation of the results of the creep life test for obtaining the Larson-Miller parameters.

The Ni-based directionally solidified alloy of the present invention preferably has a durable temperature of 960°C or more and 1010°C or less for a 1000-hour life, which is a creep life obtained from the value of the Larson-Miller parameter at the stress of 137 MPa. The 1000-hour life more preferably provides the durable temperature of 970°C or more and 1000°C or less, and most preferably provides the durable temperature of 980°C or more and 990°C or less.

If the durable temperature of the 1000-hour life as the creep life is less than 960°C, the creep life is not improved compared with those in the conventional examples. The durable temperature exceeding 1010°C is beyond an upper limit of the creep life of the Ni-based directionally solidified alloy of the present invention, even considering a testing error of the creep life test.

Regarding the Ni-based directionally solidified alloy of the present invention, it is preferable that, in a high temperature oxidation test for judging characteristics of a sample made of the Ni-based directionally solidified alloy from: a change of a weight of the sample during the high temperature oxidation test from just after being mirror-finished to after being subsequently heated at 1100°C in an electric furnace in the atmosphere and held for 12 hours; and observation of a surface of the sample, the change of the weight of the sample is -0.1 [mg/cm²] or more and 0.3 [mg/cm²] or less, and the surface of the sample has metallic luster. More preferably, the change of the weight during the high temperature oxidation test is 0.0 [mg/cm²] or more and 0.2 [mg/cm²] or less.

If the change of the weight during the high temperature oxidation test is less than -0.1 [mg/cm²], an oxidation resistance property is not improved compared with those in conventional examples. If the change during the high temperature oxidation test of the weight exceeds 0.3 [mg/cm²], the improvement of the oxidation resistance property of the Ni-based directionally solidified alloy in the present invention is not sufficient, even considering a testing error of the high temperature oxidation test.

### Advantageous Effects of Invention

The Ni-based directionally solidified alloy of the present invention has excellent TMF characteristics, creep property and environment-resistant characteristics such as high temperature oxidation resistance, and is superior in cost performance in practical use.

### Brief Description of Drawings

Fig. 1 is a graph that shows a result of a creep test at 900°C and 392 MPa and a result of a TMF test, which were conducted with respect to samples of Example 1 and Reference Examples 1 and 2.
Fig. 2 is a graph showing results of creep tests conducted at 900°C and 392 MPa and at 1100°C and 137 MPa with respect to samples of Example 1 and Reference Examples 3 and 4, which represents a relation between LMP (Larson-Miller parameter) and stress.
Fig. 3 is a graph showing durable temperatures (°C) of 1000-hour lives in creep conditions at 137 MPa, which are obtained from Fig. 2.
Fig. 4 is a view that illustrates changes of weights of samples of Examples 1 and 2 and Reference Example 5 before and after being heated at 1100°C in an electric furnace in the atmosphere and held for 12 hours.

### Description of Embodiments

A component and a composition ratio of the Ni-based directionally solidified alloy having the above-described characteristics are based on following points of view.

Cr (chromium) improves a high temperature corrosion resistance property and a high temperature oxidation resistance property of Ni-based directionally solidified alloy. A composition ratio of Cr is 6% by mass or more and 12% by mass or less. If the composition ratio is less than 6% by mass, it is difficult to secure its high temperature corrosion resistance property and high temperature oxidation resistance property, and if the composition ratio is more than 12% by mass, a toxic phase such as a σ phase and a µ phase is generated so as to decrease its high temperature strength. The composition ratio of Cr is preferably 7% by mass or more and 12% by mass or less, and is more preferably 8% by mass or more and 10% by mass or less.

Mo (molybdenum) is solved into a base, and contributes to increase the high temperature strength by precipitation hardening. A composition ratio of Mo is 0.4% by mass or more and 3.0% by mass or less. If the composition ratio is less than 0.4% by mass, the high temperature strength is decreased, and if the composition ratio is more than 3.0% by mass, a toxic phase is generated so as to decrease the high temperature strength. The composition ratio of Mo is preferably 0.4% by mass or more and 2.5% by mass or less, and is more preferably 0.4% by mass or more and 2.0% by mass or less.

W (tungsten) has effects of solid solution strengthening and precipitation hardening as well as Mo, and increases the high temperature strength of Ni-based directionally solidified alloy. A composition ratio of W is 6% by mass or more and 10% by mass or less. If the composition ratio is less than 6% by mass, a TMF characteristic and a creep property are deteriorated, and if the composition ratio is more than 10% by mass, a toxic phase is generated so as to deteriorate the TMF characteristic and the creep property. The composition ratio of W is preferably 7% by mass or more and 10% by mass or less, and is more preferably 7% by mass or more and 9% by mass or less.

Al (aluminum) is combined with Ni so as to form an intermetallic compound represented as Ni₃Al, which constitutes a gamma prime phase to be deposited in a gamma parent phase, thereby improving a TMF characteristic and a creep property particularly at a lower temperature of 1000°C or lower. A composition ratio of Al is 4.0% by mass or more and 6.5% by mass or less. If the composition ratio is less than 4% by mass, an amount of the gamma prime phase is small, and the required TMF characteristic and creep property cannot be obtained. On the other hand, if the composition ratio is more than 6.5% by mass, the required TMF characteristic and creep property cannot be obtained.

A composition ratio of Nb (niobium) is 0% by mass or more and 1% by mass or less. If the composition ratio is more than 1% by mass, a toxic phase is generated at a high temperature so as to deteriorate a TMF characteristic and a creep property.

Ta (tantalum) strengthens a gamma prime phase and improves a creep property. A composition ratio of Ta is 8% by mass or more and 12% by mass or less. If the composition ratio is less than 8% by mass, the required TMF characteristic and creep property cannot be obtained, and if the composition ratio is more than 12% by mass, generation of a eutectic gamma prime phase is promoted, and solution heat treatment becomes difficult. The composition ratio of Ta is preferably 9% by mass or more and 11% by mass or less, and is more preferably 10% by mass or more and 11% by mass or less.

Hf (hafnium) contributes to grain boundary strengthening during columnar crystallization due to directional solidification, enhances oxidation resistance, and may improve a TMF characteristic. A composition ratio of Hf is 0% by mass or more and 0.15% by mass or less. If the composition ratio is more than 0.15% by mass, generation of a toxic phase is promoted, and the TMF characteristic and a creep property are deteriorated.

Si (silicon) generates SiO₂ film on an alloy surface so as to enhance oxidation resistance as protection coating film, and can suppress generation of very small cracks on the alloy surface so as to improve an TMF characteristic. A composition ratio of Si is 0.01% by mass or more and 0.2% by mass or less. If the composition is less than 0.01% by mass, effects for enhancing the oxidation resistance and improving the TMF characteristic cannot be obtained. Further, if the composition ratio is more than 0.2% by mass, a solid solubility limit of other element is deteriorated, so that the required TMF characteristic and creep property cannot be obtained.

Zr (zirconium) is added for the purpose of strengthening crystal grain boundary of Ni-based directionally solidified alloy, and can particularly improve a TMF characteristic. A composition ratio of Zr is 0% by mass or more and less than 0.04% by mass.

B (boron) can improve a creep property, a mechanical fatigue property and the like of Ni-based directionally solidified alloy at a high temperature. A composition ratio of B is 0.01% by mass or more and 0.03% by mass or less.

C (carbon) can improve ductility, a creep property and the like of Ni-based directionally solidified alloy at a high temperature. A composition ratio of C is 0.01% by mass or more and 0. 3% by mass or less.

Further, the Ni-based directionally solidified alloy can be manufactured by treating a cast product having a predetermined composition by heat as follows. That is, the heat treatment includes: solution treatment for holding the cast product at 1280°C to 1300°C for 2 hours to 40 hours and subsequently cooling it at 200 °C/min to 400 °C/min by air or in inert gas atmosphere; primary aging treatment for holding the cast product at 1000°C to 1150°C for 2 hours to 5 hours and subsequently cooling it by air or in inert gas atmosphere; and secondary aging treatment for holding the cast product at 850°C to 950°C for 10 hours to 30 hours and subsequently cooling it by air or in inert gas atmosphere, which are carried out sequentially.

It is preferable that all of such sequential holding at the predetermined temperatures for the predetermined time periods is carried out in vacuum or inert gas atmosphere, also for not receiving the influence of the high temperature oxidation.

### Examples

Each of Ni-based directionally solidified alloys having compositions (% by mass) listed in Table 1 was melted by a vacuum melting furnace, and was casted in a lost wax mold that was heated and held, and then, the mold was lowered at a solidification rate of 200 mm/h, thereby obtaining a directionally solidified cast product. Thereafter, the obtained directionally solidified cast product was subjected to solution treatment, in which the cast product was held at 1280°C in vacuum for 5 hours and was subsequently cooled at about 300 °C/min by air. Thereafter, primary aging treatment for holding the cast product at 1100°C in vacuum for 2 hours and subsequently cooling it by air; and secondary aging treatment for holding the cast product at 870°C in vacuum for 24 hours and subsequently cooling it by air were carried out. A temperature range of solution treatment of the Ni-based directionally solidified alloys of Examples 1 and 2 were from 1260°C to 1300°C, and a temperature range of the primary aging treatment was from 1000°C to 1150°C. In Reference Examples 1 and 2, a temperature of the cast product was held at 1280°C for one hour, was increased to 1300°C, and was held for 5 hours, and then, the cast product was cooled by air. Subsequently, after holding at 1100°C for 4 hours, the cast product was cooled by air and was thereafter subjected to heat treatment, in which the temperature was held at 870°C for 20 hours and the cast product was cooled by air. Heat treatment in Reference Example 3 included: holding a temperature of the cast product at 1130°C for 1 hours, increasing it to 1180°C, holding for 2 hours and cooling it by air; thereafter holding at 1050°C for 4 hours and cooling it by air; and then, holding at 870°C for 20 hours and cooling it by air. Heat treatment in Reference Example 4 included: holding a temperature of the cast product at 1147°C for one hour, increasing to 1197°C, holding for 2 hours and cooling by air; subsequently holding at 1050°C for 4 hours and cooling by air; and then, holding at 870°C for 20 hours and cooling it by air. In Reference Example 5, the cast product was directly subjected to the test.

**[Table 1]**

| Sample | Constituent Element (% by mass) | | | | | | | | | | | | |
|---|---|---|---|---|---|---|---|---|---|---|---|---|---|
| | Co | Cr | Mo | W | Al | Ti | Nb | Hf | Zr | Ta | Si | C | B |
| Example 1 | - | 9.0 | 0.6 | 7.6 | 5.4 | - | - | 0.05 | 0.03 | 10.0 | 0.04 | 0.08 | 0.015 |
| Example 2 | - | 8.7 | 1.2 | 8.1 | 5.3 | - | 0.05 | 0.08 | 0.01 | 10.2 | 0.02 | 0.08 | 0. 015 |
| Reference Example 1 | - | 9.2 | - | 8.7 | 5.3 | - | - | 0.1 | - | 10.4 | - | 0.07 | 0.015 |
| Reference Example 2 | - | 6.6 | - | 12.8 | 5.2 | - | - | - | - | 7.7 | - | 0.07 | 0.015 |
| Reference Example 3 | 9.0 | 12.7 | 2.0 | 3.9 | 3.2 | 4.2 | - | - | 0.1 | 3.9 | - | 0.21 | 0.02 |
| Reference Example 4 | 9.5 | 14.0 | 4.0 | 4.0 | 13.0 | 5.0 | - | - | 0.03 | - | - | 0.17 | 0.015 |
| Reference Example 5 | 10 | 8.2 | 0.6 | 10 | 5.5 | 1.0 | - | - | - | 3.0 | - | 0.16 | 0.02 |

The cast product of the directionally solidified alloy after the heat treatment was processed into a creep test piece with a diameter of a parallel part of 4 mm and a length of 20 mm, and was subjected to a creep test under conditions at 900°C and 392 MPa and at 1100°C and 137 MPa. Further, a TMF test was conducted with respect to a test piece with a diameter of a parallel part of 5 mm and a length of 15 mm, while heating the test piece by high frequency waves. In the TMF test, a temperature range was changed from 400°C that was a lower limit to 900°C that was a higher limit, and ± 0.64% of stress was applied to the test piece according to this temperature change. A frequency was 66 min per one cycle, a wave form was a triangular wave, and the test piece was held for 60 min during its compression. These test conditions simulated operating conditions of a gas turbine, and were based on an assumption that a surface temperature of a turbine blade was 900°C in a steady state and was 400°C at the time of stopping. Further, an increasing/decreasing rate of the temperature was 166.7 °C/min. The TMF characteristic was evaluated by the number of cycles until the test piece was broken.

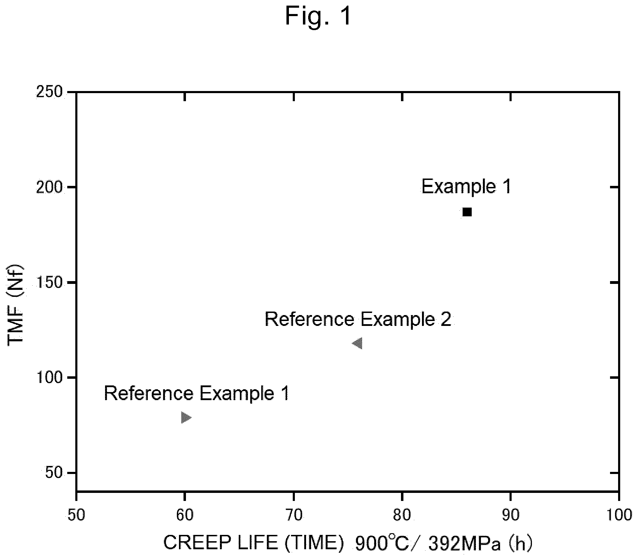

Fig. 1 shows results of the creep tests at 900°C and 392 MPa and the TMF test, which were conducted with respect to the Ni-based directionally solidified alloys of Example 1, Reference Examples 1 and 2. From Fig. 1, it can be confirmed that the Ni-based directionally solidified alloy of Example 1 had an excellent creep property and TMF characteristic.

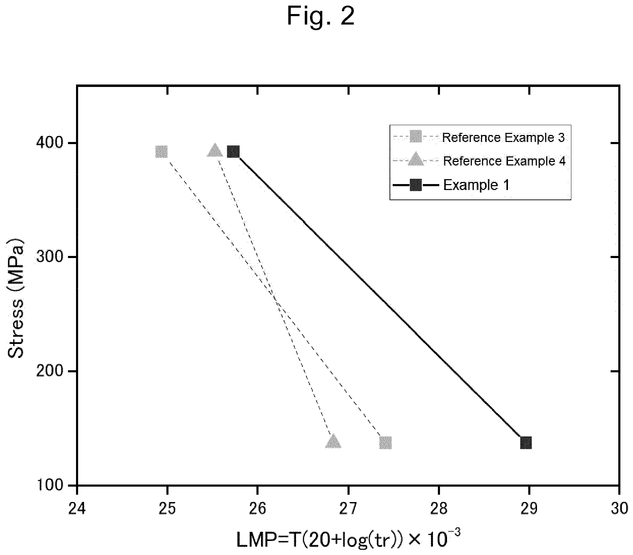

The Ni-based directionally solidified alloys of Example 1, Reference Examples 3 and 4 were subjected to the creep test under the conditions at 900°C and 392 MPa and at 1100°C and 137 MPa. Results thereof are shown in Fig. 2. LMP in a horizontal axis in Fig. 2 represents a Larson-Miller parameter, which is known as a parameter for standardizing breaking times in different temperature conditions. In Fig. 2, in a formula that defines the LMP, T represents a temperature (K), and tr represents a breaking time (h). It means that, as the LMP is larger, the Ni-based directionally solidified alloy can endure the creep at a higher temperature or for a longer time period.

Also from Figs. 1 and 2, it can be confirmed that the Ni-based directionally solidified alloy of Example 1 had a superior creep property to those of Reference Examples 1 to 4.

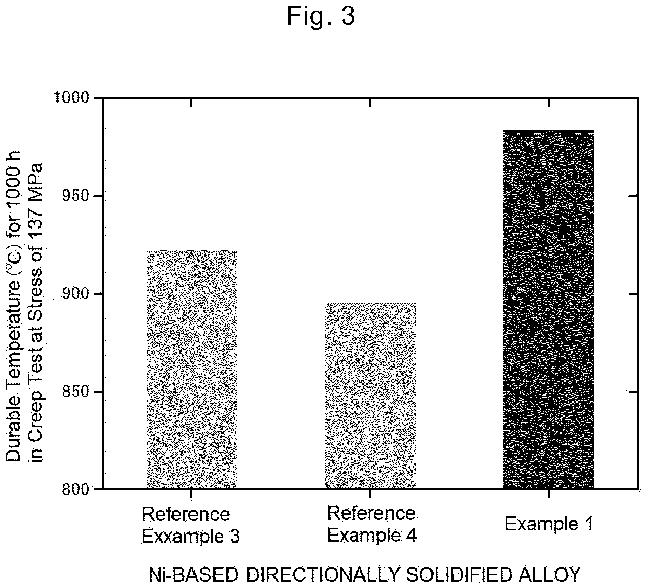

Fig. 3 shows results of durable temperatures (°C) of 1000-hour lives in the creep conditions at 137 MPa, which are obtained from the LMP diagram in Fig. 2. From the result that the durable temperature in Example 1 was 983°C, in contrast to the durable temperature (922°C) in Reference Example 3 and the durable temperature (895°C) in Reference Example 4, it can be confirmed that the Ni-based directionally solidified alloy of Example 1 was able to endure the creep at a higher temperature or for a longer time period.

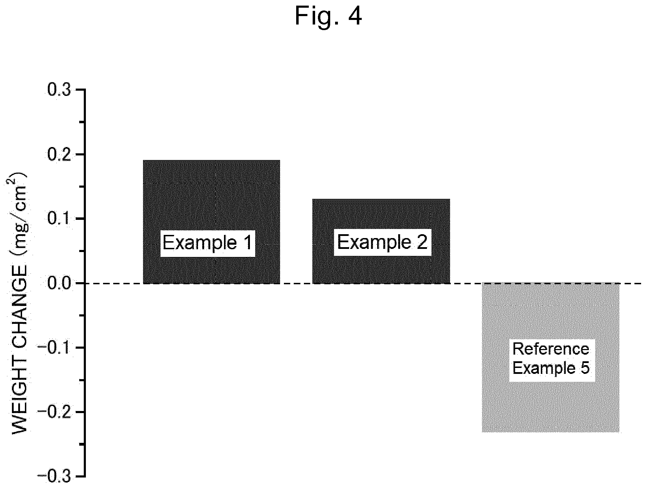

Further, a high temperature oxidation test was conducted for examining environment-resistant characteristics. In the oxidation test, each mirror-finished sample was heated at 1100°C in an electric furnace in the atmosphere and was held for 12 hours, and characteristics of each sample were evaluated from its weight change before and after heating and by observing a surface of each sample. Results of the oxidation test were as shown in Fig. 4, and the Ni-based directionally solidified alloys of Examples 1 and 2 did not lost weight or metallic luster even after 12 hours, and thus can be evaluated to have excellent oxidation resistance properties. Incidentally, the Ni-based directionally solidified alloy of Reference Example 5 shown in the figure is known as the alloy having a favorable high temperature oxidation resistance property.

### Industrial Applicability

The Ni-based directionally solidified alloy of the present invention has excellent TMF characteristics, creep property and environment-resistant characteristics such as high temperature oxidation resistance, and is superior in cost performance in practical use. Therefore, the Ni-based directionally solidified alloy of the present invention is effectively used for a member such as a turbine blade and a turbine vane in a jet engine and a gas turbine, which is used at a high temperature and high stress.

## Claims

1. Ni-based directionally solidified alloy consisting of:
Cr: 6% by mass or more and 12% by mass or less;
Mo: 0.4% by mass or more and 3.0% by mass or less;
W: 6% by mass or more and 10% by mass or less;
Al: 4.0% by mass or more and 6.5% by mass or less;
Nb: 0% by mass or more and 1% by mass or less;
Ta: 8% by mass or more and 12% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

2. The Ni-based directionally solidified alloy according to claim 1, consisting of:
Cr: 7% by mass or more and 12% by mass or less;
Mo: 0.4% by mass or more and 2.5% by mass or less;
W: 7% by mass or more and 10% by mass or less;
Al: 4.0% by mass or more and 6.5% by mass or less;
Nb: 0% by mass or more and 1% by mass or less;
Ta: 9% by mass or more and 11% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

3. The Ni-based directionally solidified alloy according to claim 2, consisting of:
Cr: 8% by mass or more and 10% by mass or less;
Mo: 0.4% by mass or more and 2.0% by mass or less;
W: 7% by mass or more and 9% by mass or less;
Al: 4.0% by mass or more and 6.5% by mass or less;
Nb: 0% by mass or more and 1% by mass or less;
Ta: 10% by mass or more and 11% by mass or less;
Hf: 0% by mass or more and 0.15% by mass or less;
Si: 0.01% by mass or more and 0.2% by mass or less;
Zr: 0% by mass or more and 0.04% by mass or less;
B: 0.01% by mass or more and 0.03% by mass or less; and
C: 0.01% by mass or more and 0.3% by mass or less, and
a balance of Ni and inevitable impurities.

4. The Ni-based directionally solidified alloy according to any one of claims 1 to 3, wherein
a creep life at a temperature of 900°C and stress of 392 MPa is 65 hours or more, and
a number of cycles in a thermo-mechanical fatigue, TMF, property test in predetermined operating conditions is 155 cycles or more.

5. The Ni-based directionally solidified alloy according to any one of claims 1 to 3, wherein
a value of a Larson-Miller parameter at a temperature of 900°C and stress of 392 MPa is 25.6 or more and 25.9 or less, and
a value of a Larson-Miller parameter at a temperature of 1100°C and stress of 137 MPa is 28.8 or more and 29.3 or less.

6. The Ni-based directionally solidified alloy according to claim 5, wherein a durable temperature is 960°C or more and 1010°C or less for a 1000-hour life, which is a creep life obtained from the value of the Larson-Miller parameter at the stress of 137 MPa.

7. A sample made of the Ni-based directionally solidified alloy according to any one of claims 1 to 3, wherein
in a high temperature oxidation test for judging characteristics of the sample from: a change of a weight of the sample from just after being mirror-finished to after being subsequently heated at 1100°C in an electric furnace in the atmosphere and held for 12 hours; and observation of a surface of the sample,
the change of the weight of the sample is -0.1 [mg/cm²] or more and 0.3 [mg/cm²] or less, and
the surface of the sample has metallic luster.

## Patentansprüche

1. Ni-basierte gerichtet erstarrte Legierung, die aus Folgendem besteht.
Cr: 6 Massen-% oder mehr und 12 Massen-% oder weniger;
Mo: 0,4 Massen-% oder mehr und 3,0 Massen-% oder weniger;
W: 6 Massen-% oder mehr und 10 Massen-% oder weniger;
Al: 4,0 Massen-% oder mehr und 6,5 Massen-% oder weniger;
Nb: 0 Massen-% oder mehr und 1 Massen-% oder weniger;
Ta: 8 Massen-% oder mehr und 12 Massen-% oder weniger;
Hf: 0 Massen-% oder mehr und 0,15 Massen-% oder weniger;
Si: 0,01 Massen-% oder mehr und 0,2 Massen-% oder weniger;
Zr: 0 Massen-% oder mehr und 0,04 Massen-% oder weniger;
B: 0,01 Massen-% oder mehr und 0,03 Massen-% oder weniger; und
C: 0,01 Massen-% oder mehr und 0,3 Massen-% oder weniger, und
wobei der Rest Ni und unvermeidbare Verunreinigungen ist.

2. Ni-basierte gerichtet erstarrte Legierung nach Anspruch 1, die aus Folgendem besteht:
Cr: 7 Massen-% oder mehr und 12 Massen-% oder weniger;
Mo: 0,4 Massen-% oder mehr und 2,5 Massen-% oder weniger;
W: 7 Massen-% oder mehr und 10 Massen-% oder weniger;
Al: 4,0 Massen-% oder mehr und 6,5 Massen-% oder weniger;
Nb: 0 Massen-% oder mehr und 1 Massen-% oder weniger;
Ta: 9 Massen-% oder mehr und 11 Massen-% oder weniger;
Hf: 0 Massen-% oder mehr und 0,15 Massen-% oder weniger;
Si: 0,01 Massen-% oder mehr und 0,2 Massen-% oder weniger;
Zr: 0 Massen-% oder mehr und 0,04 Massen-% oder weniger;
B: 0,01 Massen-% oder mehr und 0,03 Massen-% oder weniger; und
C: 0,01 Massen-% oder mehr und 0,3 Massen-% oder weniger, und
wobei der Rest Ni und unvermeidbare Verunreinigungen ist.

3. Ni-basierte gerichtet erstarrte Legierung nach Anspruch 2, die aus Folgendem besteht:
Cr: 8 Massen-% oder mehr und 10 Massen-% oder weniger;
Mo: 0,4 Massen-% oder mehr und 2,0 Massen-% oder weniger;
W: 7 Massen-% oder mehr und 9 Massen-% oder weniger;
Al: 4,0 Massen-% oder mehr und 6,5 Massen-% oder weniger;
Nb: 0 Massen-% oder mehr und 1 Massen-% oder weniger;
Ta: 10 Massen-% oder mehr und 11 Massen-% oder weniger;
Hf: 0 Massen-% oder mehr und 0,15 Massen-% oder weniger;
Si: 0,01 Massen-% oder mehr und 0,2 Massen-% oder weniger;
Zr: 0 Massen-% oder mehr und 0,04 Massen-% oder weniger;
B: 0,01 Massen-% oder mehr und 0,03 Massen-% oder weniger; und
C: 0,01 Massen-% oder mehr und 0,3 Massen-% oder weniger, und
wobei der Rest Ni und unvermeidbare Verunreinigungen ist.

4. Ni-basierte gerichtet erstarrte Legierung nach einem der Ansprüche 1 bis 3, wobei
eine Kriechlebensdauer bzw. Zeitstandfestigkeit bei einer Temperatur von 900°C und Spannung von 392 MPa 65 Stunden oder mehr ist, und
eine Anzahl von Zyklen in einem Test zu den thermomechanischen Ermüdungseigenschaften bzw. einem TMF-Test bei vorbestimmten Betriebsbedingungen 155 Zyklen oder mehr ist.

5. Ni-basierte gerichtet erstarrte Legierung nach einem der Ansprüche 1 bis 3, wobei
ein Wert eines Larson-Miller-Parameters bei einer Temperatur von 900°C und einer Spannung von 392 MPa 25,6 oder mehr und 25,9 oder weniger ist, und
ein Wert eines Larson-Miller-Parameters bei einer Temperatur von 1100°C und einer Spannung von 137 MPa 28,8 oder mehr und 29,3 oder weniger ist.

6. Ni-basierte gerichtet erstarrte Legierung nach Anspruch 5, wobei eine Warmfestigkeitstemperatur 960°C oder mehr und 1010°C oder weniger für eine Lebensdauer von 1000 Stunden ist, was eine Kriechlebensdauer bzw. Zeitstandfestigkeit ist, die von einem Wert des Larson-Miller-Parameters bei der Spannung von 137 MPa erhalten wurde.

7. Probe die aus einer Ni-basierten gerichtet erstarrte Legierung nach einem der Ansprüche 1 bis 3 gemacht ist, wobei
in einem Hochtemperaturoxidationstest zur Beurteilung von Charakteristiken der Probe eine Gewichtsänderung der Probe von einem Zeitpunkt gerade nachdem sie zu einer Spiegeloberfläche endbearbeitet wurde, bis zu einem Zeitpunk nachdem sie darauf folgend bei 1100°C in einem elektrischen Ofen in der Atmosphäre aufgeheizt wurde und für 12 Stunden gehalten wurde und eine Beobachtung der Oberfläche der Probe stattfand, die Gewichtsänderung der Probe -0,1 [mg/cm²] oder mehr und 0,3 [mg/cm²] oder weniger ist, und
wobei die Oberfläche metallischen Glanz hat.

## Revendications

1. Alliage à solidification dirigée à base de Ni constitué de :
Cr : 6 % en masse ou plus et 12 % en masse ou moins ;
Mo : 0,4 % en masse ou plus et 3,0 % en masse ou moins ;
W : 6 % en masse ou plus et 10 % en masse ou moins ;
Al : 4,0 % en masse ou plus et 6,5 % en masse ou moins ;
Nb : 0 % en masse ou plus et 1 % en masse ou moins ;
Ta : 8 % en masse ou plus et 12 % en masse ou moins ;
Hf : 0 % en masse ou plus et 0,15 % en masse ou moins ;
Si : 0,01 % en masse ou plus et 0,2 % en masse ou moins ;
Zr : 0 % en masse ou plus et 0,04 % en masse ou moins ;
B : 0,01 % en masse ou plus et 0,03 % en masse ou moins ; et
C : 0,01 % en masse ou plus et 0,3 % en masse ou moins, et
un solde de Ni et d'impuretés inévitables.

2. Alliage à solidification dirigée à base de Ni selon la revendication 1, constitué de :
Cr : 7 % en masse ou plus et 12 % en masse ou moins ;
Mo : 0,4 % en masse ou plus et 2,5 % en masse ou moins ;
W : 7 % en masse ou plus et 10 % en masse ou moins ;
Al : 4,0 % en masse ou plus et 6,5 % en masse ou moins ;
Nb : 0 % en masse ou plus et 1 % en masse ou moins ;
Ta : 9 % en masse ou plus et 11 % en masse ou moins ;
Hf : 0 % en masse ou plus et 0,15 % en masse ou moins ;
Si : 0,01 % en masse ou plus et 0,2 % en masse ou moins ;
Zr : 0 % en masse ou plus et 0,04 % en masse ou moins ;
B : 0,01 % en masse ou plus et 0,03 % en masse ou moins ; et
C : 0,01 % en masse ou plus et 0,3 % en masse ou moins, et
un solde de Ni et d'impuretés inévitables.

3. Alliage à solidification dirigée à base de Ni selon la revendication 2, constitué de :
Cr : 8 % en masse ou plus et 10 % en masse ou moins ;
Mo : 0,4 % en masse ou plus et 2,0 % en masse ou moins ;
W : 7 % en masse ou plus et 9 % en masse ou moins ;
Al : 4,0 % en masse ou plus et 6,5 % en masse ou moins ;
Nb : 0 % en masse ou plus et 1 % en masse ou moins ;
Ta : 10 % en masse ou plus et 11 % en masse ou moins ;
Hf : 0 % en masse ou plus et 0,15 % en masse ou moins ;
Si : 0,01 % en masse ou plus et 0,2 % en masse ou moins ;
Zr : 0 % en masse ou plus et 0,04 % en masse ou moins ;
B : 0,01 % en masse ou plus et 0,03 % en masse ou moins ; et
C : 0,01 % en masse ou plus et 0,3 % en masse ou moins, et
un solde de Ni et d'impuretés inévitables.

4. Alliage à solidification dirigée à base de Ni selon l'une quelconque des revendications 1 à 3, dans lequel
une durée de vie au fluage à une température de 900 °C et sous une contrainte de 392 MPa est de 65 heures ou plus, et
un certain nombre de cycles dans un test de propriété fatigue thermo-mécanique, TMF, dans des conditions de fonctionnement prédéterminées est de 155 cycles ou plus.

5. Alliage à solidification dirigée à base de Ni selon l'une quelconque des revendications 1 à 3, dans lequel
une valeur d'un paramètre de Larson-Miller à une température de 900 °C et sous une contrainte de 392 MPa est de 25,6 ou plus et 25,9 ou moins, et
une valeur d'un paramètre de Larson-Miller à une température de 1100 °C et sous une contrainte de 137 MPa est de 28,8 ou plus et de 29,3 ou moins.

6. Alliage à solidification dirigée à base de Ni selon la revendication 5, dans lequel une température durable est de 960 °C ou plus et de 1010 °C ou moins pour une durée de vie de 1000 heures, qui est une durée de vie au fluage obtenue à partir de la valeur du paramètre Larson-Miller sous la contrainte de 137 MPa.

7. Échantillon constitué de l'alliage à solidification dirigée à base de Ni selon l'une quelconque des revendications 1 à 3, dans lequel
dans un test d'oxydation à haute température pour juger des caractéristiques de l'échantillon à partir de : une modification du poids de l'échantillon depuis juste après avoir été miroir fini jusqu'après avoir été ensuite chauffé à 1100 °C dans un four électrique à pression atmosphérique et maintenu pendant 12 heures ; et l'observation d'une surface de l'échantillon,
la modification du poids de l'échantillon est de -0,1 [mg/cm²] ou plus et de 0,3 [mg/cm²] ou moins, et
la surface de l'échantillon a un lustre métallique.
